(19) Europäisches Patentamt
European Patent Office
Office européen des brevets

(11) **EP 3 186 647 B1**

(12) **FASCICULE DE BREVET EUROPEEN**

(45) Date de publication et mention de la délivrance du brevet:
**11.11.2020 Bulletin 2020/46**

(51) Int Cl.:
***G01R 27/32*** *(2006.01)*

(21) Numéro de dépôt: **15754201.0**

(86) Numéro de dépôt international:
**PCT/EP2015/069323**

(22) Date de dépôt: **24.08.2015**

(87) Numéro de publication internationale:
**WO 2016/030314 (03.03.2016 Gazette 2016/09)**

(54) **PROCÉDÉ DE DÉTERMINATION DE PARAMÈTRES LINÉIQUES D'UNE LIGNE DE TRANSMISSION**

VERFAHREN ZUR BESTIMMUNG VON LINEAREN PARAMETERN EINER ÜBERTRAGUNGSLEITUNG

METHOD FOR DETERMINING LINEAR PARAMETERS OF A TRANSMISSION LINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.08.2014 FR 1457980**

(43) Date de publication de la demande:
**05.07.2017 Bulletin 2017/27**

(73) Titulaire: **Commissariat à l'Énergie Atomique et aux Énergies Alternatives 75015 Paris (FR)**

(72) Inventeurs:
 • COHEN, Josy
 F-94420 Le Plessis Trevise (FR)
 • GREGIS, Nicolas
 F-94260 Fresnes (FR)

(74) Mandataire: **Marks & Clerk France Immeuble "Visium" 22, avenue Aristide Briand 94117 Arcueil Cedex (FR)**

(56) Documents cités:
 **WO-A1-2014/065674    US-A- 5 502 392 US-A1- 2011 071 776**

 • **DOUNAVIS A ET AL: "Passive Closed-Form Transmission Line Macromodel Using Method of Characteristics", IEEE TRANSACTIONS ON ADVANCED PACKAGING, IEEE SERVICE CENTER, PISCATAWAY, NJ, USA, vol. 31, no. 1, 1 février 2008 (2008-02-01), pages 190-202, XP011346175, ISSN: 1521-3323, DOI: 10.1109/TADVP.2007.909449**
 • **"Spectrum management for loop transmission systems", INTERNET CITATION, 1999, XP002178517, Extrait de l'Internet: URL:http://ftp.tiaonline.org/tr-41/TR419/WORKING/8-99/-046%20T1E1.pdf [extrait le 2001-09-26]**

**EP 3 186 647 B1**

**Description**

La présente invention concerne le domaine des systèmes et procédés de diagnostic pour câble et en particulier le domaine des méthodes de réflectométrie permettant de détecter et/ou localiser les défauts impactant un câble.

L'invention porte plus précisément sur un procédé permettant de déterminer les paramètres linéiques d'une ligne de transmission tels que la résistance linéique, l'inductance linéique, la capacitance linéique et la conductance linéique.

De tels paramètres présentent une importance pour caractériser un câble et peuvent être utiles dans le cadre du diagnostic filaire basé sur une méthode de réflectométrie.

En particulier les paramètres linéiques déterminés grâce à la présente invention peuvent être utilisés comme données d'entrée du procédé de réflectométrie décrit dans la demande de brevet française du Demandeur déposée sous le numéro FR 1355377.

Mais ils peuvent également être utilisés pour d'autres applications qui nécessitent la connaissance des ces paramètres, par exemple ils peuvent être employés pour simuler un réseau de câbles complexe pour permettre le diagnostic de défauts à partir de cet environnement simulé.

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées, en toron de câble ou autre. L'invention peut également s'appliquer à des câbles mécaniques, par exemple des câbles de soutien d'infrastructures telles un ascenseur ou un pont.

Les paramètres linéiques d'une ligne de transmission ne sont pas toujours connus ni fournis dans une documentation du fabricant de câble. En outre, les données fournies par les constructeurs de câble ne permettent pas toujours de déterminer avec une précision suffisante ces paramètres.

On connait par ailleurs les méthodes décrites dans les publications [1],[2] et [3]. Ces méthodes présentent les limitations suivantes. Elles nécessitent le plus souvent au moins deux points de mesure sur le câble à tester, par exemple un point de mesure en entrée et un point de mesure en sortie ou deux points de mesure en entrée en modifiant, entre les deux mesures, la charge en entrée. En outre ces méthodes présentent l'inconvénient d'être sensibles aux défauts électriques qui viennent perturber les mesures des paramètres linéiques obtenus. L'art antérieur supplémentaire est décrit dans WO 2014/065674 A1, US 2011/071776 A1, US 5 502 392 A, Dounavis A. et al: "Passive Closed-Form Transmission Line Macromodel Using Method of Characteristics" (IEEE Transactions on Advanced Packaging) et dans "Spectrum management for loop transmission systems" (TR41.9/99-08-046 American National Standard for Télécommunications).

A partir d'une mesure en réflectométrie temporelle ou fréquentielle, la présente invention permet d'extraire, par un ensemble de calcul, les paramètres linéiques intrinsèques et génériques au câble et représentatifs de la propagation d'un signal électromagnétique au sein dudit câble, sur une plage de fréquence recherchée qui peut être plus large que la bande de fréquence du signal sonde.

Les paramètres linéiques d'un câble sont la résistance linéique R, l'inductance linéique L, la capacitance linéique C et la conductance linéique G. Dans la suite de la description ces paramètres seront désignés par l'appellation paramètres RLCG.

L'invention a pour objet un procédé de détermination d'au moins un paramètre linéique d'une ligne de transmission, ledit procédé comprenant les étapes suivantes :

- Déterminer au moins une mesure du facteur de propagation complexe $\gamma$ en fonction de la fréquence à partir d'au moins une mesure réalisée sur la ligne de transmission,
- Déterminer au moins une mesure de l'atténuation linéique $\alpha$ de la ligne de transmission égale à la partie réelle de la mesure du facteur de propagation complexe $\gamma$ et/ou au moins une mesure du facteur de phase $\beta$ de la ligne de transmission égale à la partie imaginaire de la mesure du facteur de propagation complexe $\gamma$,
- Filtrer la mesure de l'atténuation linéique $\alpha$ et/ou la mesure du facteur de phase $\beta$ à partir d'un modèle de régression polynomial en fréquence dépendant des caractéristiques physiques de la ligne de transmission.

Selon un aspect particulier de l'invention, le modèle de régression pour l'atténuation linéique est du type

$$\alpha(f) = a_0\sqrt{f} + a_1 f \quad ,$$

où $a_0$ et $a_1$ sont deux nombres réels.

Selon un aspect particulier de l'invention, le modèle de régression pour le facteur de phase est du type $\beta(f) = b_0 f$ où $b_0$ est un nombre réel.

Selon un aspect particulier, le procédé selon l'invention comporte en outre la détermination d'une estimée d'au moins un paramètre linéique de la ligne de transmission parmi la résistance linéique, l'inductance linéique, la capacitance linéique ou la conductance linéique, à partir d'au moins une mesure parmi la mesure filtrée de l'atténuation linéique, la mesure filtrée du facteur de phase et la mesure du coefficient de réflexion $\rho_e$ à une première extrémité de la ligne de transmission, la dite estimée étant déterminée comme une fonction polynomiale de la fréquence.

Selon un aspect particulier, le procédé selon l'invention comporte en outre les étapes suivantes :

- Déterminer une nouvelle estimée $X_i$ d'un paramètre caractéristique de la propagation dans la ligne de transmission à partir de ladite estimée d'au moins un paramètre linéique de la ligne de transmission,
- Mesurer le degré de similitude entre la nouvelle estimée $X_{ii}$ et une mesure X du même paramètre caractéristique.

Selon un aspect particulier de l'invention, le paramètre caractéristique de la propagation dans la ligne de transmission est le facteur de propagation complexe $\gamma$ ou une fonction de ce paramètre.

Selon un aspect particulier de l'invention, la mesure du facteur de propagation complexe $\gamma$ est déterminée à l'aide des étapes suivantes :

- Déterminer une mesure H de la fonction de transfert fréquentielle de la ligne de transmission,
- Déterminer une mesure du coefficient de réflexion $\rho_e$ à une première extrémité de la ligne de transmission,
- Déterminer une mesure du facteur de propagation complexe $\gamma$ à partir de la mesure H de la fonction de transfert fréquentielle, de la mesure du coefficient de réflexion $\rho_e$ à une première extrémité de la ligne de transmission et d'une estimée de la longueur de la ligne de transmission,

Selon un aspect particulier de l'invention, la mesure H de la fonction de transfert fréquentielle de la ligne de transmission est déterminée à l'aide d'une méthode de réflectométrie fréquentielle à partir de l'injection, à une première extrémité de la ligne, d'un signal de réflectométrie.

Selon un aspect particulier de l'invention, la mesure du coefficient de réflexion $\rho_e$ en entrée de la ligne de transmission est déterminée par une moyenne, sur une bande fréquentielle donnée, de la mesure H de la fonction de transfert fréquentielle de la ligne de transmission.

Selon un aspect particulier de l'invention, la mesure H de la fonction de transfert fréquentielle de la ligne de transmission est déterminée à l'aide d'une méthode de réflectométrie temporelle à partir de l'injection, à une première extrémité de la ligne, d'un signal de réflectométrie.

Selon un aspect particulier de l'invention, la mesure du coefficient de réflexion $\rho_e$ en entrée de la ligne de transmission est déterminée par la mesure de l'amplitude du pic du signal de réflectométrie réfléchi au point d'injection.

Selon un aspect particulier, le procédé selon l'invention comporte en outre les étapes suivantes :

- Déterminer une mesure de l'impédance caractéristique $Z_c$ de la ligne de transmission ou une mesure du coefficient de réflexion à une seconde extrémité de la ligne de transmission à partir de la mesure du coefficient de réflexion $\rho_e$ à une première extrémité de la ligne de transmission.
- Déterminer une mesure du facteur de propagation complexe $\gamma$ à partir de la mesure H de la fonction de transfert fréquentielle et de la mesure de l'impédance caractéristique $Z_c$ de la ligne de transmission ou de la mesure du coefficient de réflexion à une seconde extrémité de la ligne de transmission.

Selon un aspect particulier de l'invention, le paramètre caractéristique de la propagation dans la ligne de transmission est la fonction de transfert fréquentielle H ou l'impédance caractéristique $Z_c$ ou une fonction de l'un de ses paramètres.

Selon un aspect particulier de l'invention, le degré de similitude est mesuré par le calcul d'un coefficient de détermination entre la nouvelle estimée d'un paramètre caractéristique $X_i$ de la propagation dans la ligne de transmission et la mesure X du même paramètre caractéristique.

Selon un aspect particulier, le procédé selon l'invention comporte en outre les étapes suivantes :

- Déterminer une nouvelle estimée $\gamma_i$ du facteur de propagation complexe de la ligne de transmission à partir des estimées de la résistance linéique, de l'inductance linéique, de la capacitance linéique et de la conductance linéique de la ligne de transmission,
- exécuter les étapes du procédé permettant de déterminer une estimée d'au moins un paramètre linéique de la ligne de transmission à partir de la nouvelle estimée $\gamma_i$ du facteur de propagation complexe.

Selon un aspect particulier de l'invention, les étapes du procédé sont itérées un nombre donné de fois et les paramètres linéiques retenus sont ceux déterminés à l'itération correspondant au degré de similitude le plus élevé.

Selon un aspect particulier de l'invention, les étapes du procédé sont itérées tant que le degré de similitude n'a pas atteint une valeur donnée.

Selon un aspect particulier de l'invention, la ligne de transmission est un câble coaxial ou un câble bifilaire ou un câble torsadé.

Selon un aspect particulier, le procédé selon l'invention comporte en outre une étape de décimation en fréquence appliquée à une pluralité de mesures de l'atténuation linéique $\alpha$ et/ou de mesures du facteur de phase $\beta$ avant l'étape de filtrage.

L'invention a aussi pour objet un programme d'ordinateur comportant des instructions pour l'exécution du procédé de détermination d'au moins un paramètre linéique d'une ligne de transmission selon l'invention, lorsque le programme est exécuté par un processeur et un dispositif comprenant des premiers moyens de mesure connectés à une ligne de transmission et des seconds moyens de calcul configurés pour exécuter le procédé de détermination d'au moins un paramètre linéique d'une ligne de transmission selon l'invention.

D'autres caractéristiques et avantages de la présente invention apparaîtront mieux à la lecture de la description qui suit en relation aux dessins annexés qui représentent :

- La figure 1, un schéma de principe d'un câble à tester dont on souhaite déterminer les paramètres linéiques par application du procédé selon l'invention,
- La figure 2, un organigramme décrivant les étapes du procédé selon l'invention,

Les paramètres linéiques d'une ligne de transmission R, L, C et G apparaissent dans les équations bien connues dites des télégraphistes qui permettent de décrire l'évolution de la tension et du courant sur une ligne électrique en fonction de la distance et du temps. Une portion de ligne électrique peut être représentée par un quadripôle comprenant une résistance linéique R, une inductance linéique L, une capacitance linéique C et une conductance linéique G.

L'usage de ce modèle à constantes réparties R, L, C et G possède de nombreux avantages pour modéliser la propagation d'une onde sur un câble. Ce modèle offre en effet une description fréquentielle indépendante de la longueur lié à quatre paramètres définis par la géométrie du câble ainsi que sa composition matérielle. La résistance R et l'inductance L sont directement liées aux conducteurs métalliques du câble et à leurs dimensions tandis que la capacitance C et la conductance G décrivent la nature du diélectrique utilisé pour séparer ces conducteurs. Les paramètres R,L,C,G se calculent à partir des équations de Maxwell.

Cette modélisation permet de caractériser un câble en déduisant par exemple la vitesse de propagation ainsi que l'atténuation ou encore l'impédance caractéristique du câble qui régissent la propagation de n'importe quel signal dans ce câble.

Cependant, s'il existe un lien direct entre ces trois grandeurs précitées et les quatre paramètres RLCG, il n'est pas forcément évident de pouvoir les déduire d'une mesure issue de méthodes de réflectométrie. La faute en revient à l'estimation peu précise des trois grandeurs que sont la vitesse de phase, l'atténuation et principalement l'impédance caractéristique, dont la partie imaginaire est particulièrement compliquée à estimer correctement. L'erreur générée par les méthodes de calcul usuelles basées sur l'isolation du pic de désadaptation (en réflectométrie temporelle) et l'étude de l'amplitude de sa transformée de Fourier, est suffisante pour provoquer un écart important dans le calcul des paramètres RLCG, particulièrement pour la conductance G qui peut accuser un écart de plus de 100% par rapport à la théorie.

De plus, dans le domaine de la réflectométrie fréquentielle, les méthodes existantes sont très contraignantes car elles nécessitent d'avoir un accès à chaque extrémité du câble. Elles souffrent d'ailleurs de la même imprécision que les méthodes de réflectométrie temporelle.

L'invention est basée sur le principe que le câble étudié peut être décrit par l'ensemble des quatre paramètres RLCG, ce qui implique qu'il est quasi homogène sur toute sa longueur. De plus, ces paramètres RLCG respectent certaines propriétés mathématiques comme la continuité en fréquence, et des propriétés physiques comme le fait qu'ils sont forcément positifs. L'invention présente de bons résultats également dans le cas où le câble est impacté par des défauts non francs qui induisent une variation locale d'impédance de l'ordre de quelques % par rapport à l'impédance caractéristique du câble et qui sont de faibles dimensions.

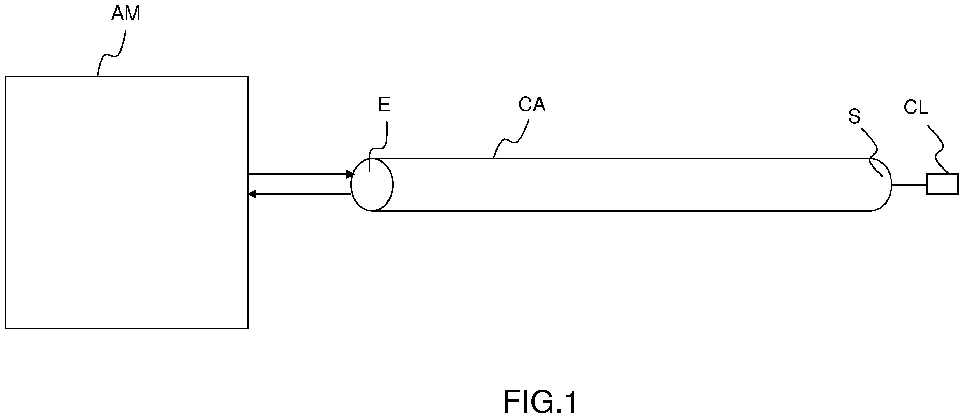

On définit les paramètres suivants utilisés dans la suite de la description et en référence à la figure 1 qui donne un schéma de principe d'un câble sous test CA relié à son entrée E à un appareil de mesure AM adapté à effectuer une mesure de réflectométrie en vue d'obtenir une mesure de la fonction de transfert du câble. L'extrémité opposée S, de sortie, du câble est reliée à une charge en bout de ligne CL.

$Z_C$ est l'impédance caractéristique du câble CA,

$\gamma$ est le facteur de propagation complexe du câble CA,

$\alpha$ est l'atténuation linéique du câble CA qui est égale à la partie réelle du facteur de propagation complexe,

$\beta$ est le facteur de phase du câble CA qui est égal à la partie imaginaire du facteur de propagation complexe,

$Z_G$ est l'impédance en entrée E du câble CA, c'est-à-dire en sortie de l'appareil de mesure AM connecté en entrée E du câble pour réaliser une mesure de réflectométrie,

$Z_F$ est l'impédance de la charge CL en bout de ligne, c'est à dire à l'extrémité S opposée du câble, $\rho_e = \frac{Z_C - Z_G}{Z_C + Z_G}$ est le coefficient de réflexion dû à la désadaptation entre le câble CA et l'appareil de mesure AM, autrement dit le coefficient de réflexion en entrée E du câble, $\rho_f = \frac{Z_f - Z_C}{Z_f + Z_C}$ est le coefficient de réflexion dû à la charge CL en bout de ligne, c'est-à-dire le coefficient de réflexion en sortie S du câble,

l est la longueur du câble et H est la fonction de transfert fréquentielle du câble.

Les équations des télégraphistes, issues de la modélisation d'une ligne de transmission par constante répartie, permettent de relier les paramètres RLCG d'une ligne à son impédance caractéristique $Z_c$ et au facteur de propagation $\gamma$ dans le sens dit direct, f est la fréquence du signal se propageant le long de la ligne.

$$Z_c = \sqrt{(R + i2\pi f L)/(G + i2\pi f C)} \qquad (i)$$

$$\gamma = \sqrt{(R + i2\pi f L) * (G + i2\pi f C)} \qquad (ii)$$

Les équations (i) et (ii) montrent qu'il est possible de déterminer les paramètres RLCG à partir de la connaissance de l'impédance caractéristique et du facteur de propagation :

$$\begin{cases} R = \Re e\{\gamma Z_c\} \\ G = \Re e\{\gamma/Z_c\} \\ L = \Im m\{\gamma Z_c\}/2\pi f \\ C = \Im m\{\gamma/Z_c\}/2\pi f \end{cases} \qquad (iii)$$

Re() désigne la fonction partie réelle et Im() désigne la fonction partie imaginaire.

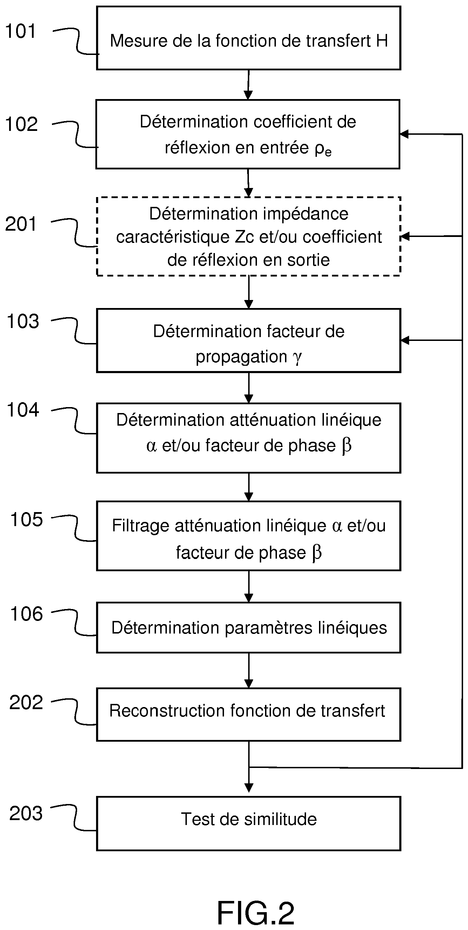

La figure 2 décrit, sur un organigramme, les étapes de mise en œuvre du procédé selon l'invention.

Selon une première étape 101, on effectue une mesure de la fonction de transfert fréquentielle H du câble à analyser. Cette étape est réalisée à l'aide d'un appareil de mesure AM adapté à effectuer une mesure de réflectométrie. Cette mesure consiste en l'injection d'un signal de réflectométrie à l'entrée E du câble connectée à l'appareil de mesure AM puis une mesure du signal réfléchi. De nombreuses méthodes de réflectométrie existent dans l'état de l'art, elles ne sont pas décrites ici car elles ne font pas l'objet de l'invention. On peut cependant distinguer d'une part les méthodes de réflectométrie temporelles qui analysent le signal réfléchi dans le domaine temporel et les méthodes de réflectométrie fréquentielles qui analysent le signal réfléchi dans le domaine fréquentiel.

Si une méthode fréquentielle est utilisée, l'appareil de mesure AM délivre directement un réflectogramme fréquentiel qui est égal à la fonction de transfert en fréquence du câble sur toute la gamme de fréquence analysée.

Si une méthode temporelle est utilisée, l'appareil de mesure AM délivre un réflectogramme temporel auquel il faut appliquer une transformée en fréquence, par exemple une transformée de Fourier, puis diviser le résultat par la transformée de Fourier du signal de réflectométrie injecté dans le câble.

Sans sortir du cadre de l'invention, toute autre méthode de réflectométrie ou toute méthode d'analyse permettant de déterminer, à partir de mesures faites sur un câble, la fonction de transfert en fréquence de ce câble entrent dans la portée de l'invention.

Dans une deuxième étape 102 du procédé selon l'invention, on détermine ensuite une mesure du coefficient de réflexion $\rho_e$ dû à la désadaptation entre le câble et l'appareil de mesure AM, autrement dit le coefficient de réflexion en entrée E du câble.

Plus précisément, on mesure la partie réelle du coefficient de réflexion $\rho_e$. Cette mesure peut être réalisée à partir du réflectogramme mesuré par l'appareil de mesure AM. Si une méthode de réflectométrie temporelle est utilisée, la partie réelle du coefficient de réflexion $\rho_e$ est obtenue en mesurant, au point d'injection E du signal de réflectométrie, l'amplitude du pic de désadaptation dans le réflectogramme correspondant au signal réfléchi.

Si une méthode de réflectométrie fréquentielle est utilisée, alors cette mesure est obtenue en effectuant la moyenne de la partie réelle de la fonction de transfert fréquentielle H sur la bande de fréquence considérée.

Il est connu que la fonction de transfert fréquentielle est liée aux coefficients de réflexion en entrée et en sortie du câble ainsi qu'au facteur de propagation par la relation suivante, où l est la longueur du câble :

$$H(\omega) = \rho_e + \frac{(1-\rho_e^2)\rho_f e^{-2\gamma l}}{1+\rho_e\rho_f e^{-2\gamma l}} \qquad\qquad\qquad\text{(iv)}$$

Selon une troisième étape 201, il est possible de déterminer, à partir de la mesure de la partie réelle du coefficient de réflexion $\rho_e$, une mesure de la partie réelle de l'impédance caractéristique $Z_c$ et/ou une mesure de la partie réelle du coefficient de réflexion $\rho_f$ en bout de ligne S. Ces mesures peuvent être obtenues à l'aide des relations introduites ci-dessus reliant ces différents paramètres entre eux et à partir de la connaissance de l'impédance $Z_G$ en sortie de l'appareil de mesure AM et de l'impédance $Z_F$ de la charge CL en bout de ligne.

Cette troisième étape 201 est optionnelle dans la mesure où le calcul d'une estimée du facteur de propagation peut être fait à partir de la seule connaissance de l'une des trois mesures $\rho_e$, $Z_c$ ou $\rho_f$ comme cela se déduit de la relation (vi) et sachant que ces trois grandeurs sont reliées entre elles par des relations linéaires.

A partir de la relation (iv) on peut déterminer la grandeur $H_1$ en retranchant à la mesure H de la fonction de transfert, la

$$H_1 = H - \rho_e = r + \frac{(1-\rho_e^2)\rho_f e^{-2\gamma l}}{1+\rho_e\rho_f e^{-2\gamma l}}$$

mesure de la partie réelle du coefficient de réflexion $\rho_e$. où r est le reste provenant de l'estimation incomplète de $\rho_e$. (v)

A partir des relations (iv) et (v) on peut déterminer le facteur de propagation grâce à la relation (vi) :

$$\gamma = \frac{1}{2l}\ln\frac{(1-\rho_e^2)\rho_f - \rho_e\rho_f H_1}{H_1} \qquad\qquad\qquad\text{(vi)}$$

A partir de la relation (vi), on voit qu'il est possible d'estimer 103 une mesure du facteur de propagation à partir de $H_1$, $\rho_e$, et $\rho_f$ et de la connaissance de la longueur du câble I. Alternativement, $\rho_f$ peut être remplacé par son expression en fonction de $\rho_e$. Il est aussi possible de faire intervenir l'impédance caractéristique $Z_c$ dans l'expression (vi).

Dans une étape supplémentaire 104, on détermine ensuite les valeurs de l'atténuation linéique $\alpha$ et du facteur de phase $\beta$ qui sont respectivement égales à la partie réelle et à la partie imaginaire du facteur de propagation $\gamma$.

On précise que toutes les grandeurs calculées à partir de la fonction de transfert H dépendent de la fréquence et sont ainsi mesurées pour plusieurs valeurs de fréquences dans une bande fréquentielle de mesure prédéfinie.

Sans sortir du cadre de l'invention, d'autres méthodes sont envisageables pour déterminer, à partir d'au moins une mesure réalisée sur un câble à tester, une estimée du facteur de propagation $\gamma$. Par exemple, les étapes précitées 101,102,201,103 peuvent être remplacées par la méthode décrite dans la référence [1] qui se base sur la mesure d'un réflectogramme temporel. La méthode décrite dans la référence [6] peut également être utilisée.

Du fait des imperfections liées à une mesure non parfaite du coefficient de réflexion $\rho_e$, notamment du fait qu'on ne mesure que sa partie réelle, les estimées des paramètres $\alpha$ et $\beta$ sont entachées d'erreurs qui apparaissent sous la forme de variations ou d'oscillations périodiques autour de la valeur réelle.

Pour lutter contre ces variations, il est nécessaire d'opérer un filtrage 105 des paramètres $\alpha$ et $\beta$.

Pour réaliser cette étape de filtrage 105, plusieurs solutions sont possibles.

Une solution consiste à effectuer un filtrage par régression linéaire ou non linéaire. Pour cela, on détermine un modèle de variation, en fonction de la fréquence, des paramètres $\alpha$ et $\beta$. Ce modèle dépend du type de câble visé et en particulier de ses caractéristiques physiques.

Pour un câble du type câble coaxial ou câble bifilaire ou encore câble torsadé, un modèle possible est donné par les relations (vii) et (viii) :

$$\alpha(f) = a_0\sqrt{f} + a_1 f \qquad\qquad\qquad\text{(vii)}$$

$$\beta(f) = b_0 f \qquad\qquad\qquad\text{(viii)}$$

Les nombres réels $a_0$, $a_1$ et $b_0$ sont les paramètres de la régression. Un modèle linéaire est choisi pour le facteur de phase ce qui permet de représenter l'aspect faiblement dispersif des câbles précités. Un modèle non linéaire utilisant un polynôme en racine carré de la fréquence est choisi pour l'atténuation linéique afin de tenir compte de deux types de pertes principales : les pertes métalliques et les pertes diélectriques.

De façon générale, le modèle d'évolution des grandeurs $\alpha$ et $\beta$ est établi à partir de connaissances des caractéristiques physiques du câble à analyser.

Sans sortir du cadre de l'invention, les modèles d'évolution des paramètres $\alpha$ et $\beta$ peuvent prendre la forme de toute fonction polynomiale de la fréquence.

A partir des mesures obtenues à l'issu de l'étape 104 et des modèles donnés par les relations (vii) et (viii), on effectue une régression selon le critère des moindres carrés de sorte à approximer au mieux les paramètres de la régression à partir des mesures effectuées à l'étape 104.

D'autres méthodes de filtrage sont envisageables, par exemple un filtrage par moyenne glissante ou un filtrage par transformée de Fourier ou toute autre méthode permettant de filtrer les variations des mesures des paramètres $\alpha$ et $\beta$ autour d'une valeur cible.

Pour améliorer encore la précision des résultats, selon une autre variante de réalisation de l'invention, une étape supplémentaire de décimation fréquentielle est réalisée avant l'opération de filtrage effectuée sur les grandeurs $\alpha$ et $\beta$. Autrement dit, si les mesures des paramètres $\alpha$ et $\beta$ sont réalisées pour un nombre N de valeurs de fréquences dans une bande de fréquence donnée $[F_{min} \ F_{max}]$, on sélectionne un sous ensemble de ces valeurs avant d'appliquer l'opération de filtrage.

Par exemple, une solution consiste à retirer au moins un point de mesure dans les basses fréquences de la bande considérée ou dans les hautes fréquences ou alternativement dans les basses fréquences puis dans les hautes fréquences. Comme cela est explicité plus en avant de la description, le procédé selon l'invention peut être exécuté de façon itérative. Dans ce cas, à chaque itération, au moins un point de mesure différent peut être retiré de l'ensemble des mesures disponibles pour $\alpha$ et $\beta$.

Ce processus permet d'éliminer les valeurs de $\alpha$ et $\beta$ qui présentent des distorsions trop importantes et d'assurer une convergence vers des valeurs stables pour les paramètres de la régression linéaire.

Le procédé selon l'invention peut être interrompu après le calcul des paramètres $\alpha$ et $\beta$ qui peuvent être exploités en tant que tels pour l'information qu'ils contiennent.

Si l'on souhaite déterminer une estimée des paramètres linéiques RLCG, une étape supplémentaire 106 doit être exécutée.

Selon cette étape supplémentaire 106, on détermine une estimée des paramètres linéiques RLCG à partir des mesures filtrées des paramètres $\alpha$ et $\beta$.

Ces estimées peuvent être obtenues à partir des équations (iii) et des paramètres de la régression linéaire donnés par les équations (vii) et (viii).

$$\begin{cases} l = Z_G \dfrac{(1+\rho_e)}{2\pi(1-\rho_e)} b_0 \\[2mm] r = \dfrac{4a_0 l\pi}{b_0} \\[2mm] c = \dfrac{b_0^3}{4\sqrt{4a_1^2 l^2 + b_0^2 l^2 \pi^2}} \\[2mm] g = \dfrac{a_1 b_0^2}{\sqrt{(4a_1^2 + b_0^2)l^2 \pi}} \end{cases} \qquad \text{(ix)}$$

$$\begin{cases} L = l \\ R = r\sqrt{f} \\ C = c \\ G = gf \end{cases} \qquad \text{(x)}$$

Les relations (x) donnent également un modèle d'évolution des paramètres RLCG en fonction de la fréquence qui dépend des caractéristiques physiques du câble. C'est pourquoi les expressions (x) sont valables pour des câbles du type câble coaxial ou câble bifilaire ou câble torsadé.

Les relations (x) peuvent prendre la forme de fonctions polynomiales de la fréquence d'ordre supérieur à celles décrites ci-dessus dans le cas de câble différents, par exemple dans le cas de câbles en toron.

Selon une variante particulière de réalisation de l'invention, le procédé peut être itéré plusieurs fois afin d'améliorer le filtrage 105 des erreurs sur les paramètres $\alpha$ et $\beta$.

Pour cela, dans une étape supplémentaire 202, on effectue une reconstruction $H_i$ de la fonction de transfert fréquentielle du câble à partir des paramètres RLCG estimés à l'étape 106 grâce aux relations (x).

Cette reconstruction peut être obtenue à l'aide d'une méthode basée sur une matrice chaine telle que décrite par exemple dans l'un des documents [4] ou [5].

Un test de similitude 203 peut être effectué pour mesurer le degré de similitude entre la fonction de transfert reconstruite $H_i$ à l'issue de l'étape 202 et la fonction de transfert H mesurée initialement à l'étape 101.

Ce test peut par exemple être réalisé en calculant le coefficient de détermination R entre les deux fonctions de transfert Hi et H ou à partir d'un coefficient de vraisemblance V défini par la relation $V^2 = -\log(1-R^2)$.

Dans une variante de réalisation de l'invention, les étapes 202,203 peuvent être réalisées en remplaçant la fonction de transfert fréquentielle H par tout autre paramètre caractéristique X de la propagation dans la ligne de transmission. En particulier, la fonction de transfert H peut être remplacée par le facteur de propagation $\gamma$ ou par l'impédance caractéristique $Z_c$ ou encore par une fonction de l'un de ces paramètres. Dans ce cas le degré de similitude est déterminé en comparant l'estimée et la mesure du paramètre X de la même façon que celle introduite ci-dessus pour la fonction de transfert H.

A chaque itération du procédé, on recalcule, à partir des paramètres R, L, C, G estimés à l'étape 106, l'impédance caractéristique $Z_c$ à l'aide de la relation (i) puis le coefficient de réflexion en entrée et/ou le coefficient de réflexion en sortie à partir des relations qui les lient à l'impédance caractéristique. Les étapes 103,104,105,106 sont ensuite exécutées à partir de ces nouvelles valeurs.

Alternativement, il est également possible de déterminer directement une nouvelle valeur du facteur de propagation $\gamma$ à partir de la relation (ii) puis d'exécuter ensuite les étapes 104,105,106 pour déterminer de nouveaux paramètres linéiques.

A chaque itération du procédé, on mémorise les paramètres linéiques obtenus associés au degré de similitude calculé à l'étape 203. Au bout d'un nombre donné d'itérations, on conserve in fine les paramètres correspondants au degré de similitude le plus élevé, c'est-à-dire pour lequel la fonction de transfert reconstruite à l'étape 202 est la plus proche de celle mesurée à l'étape 101.

Le fonctionnement itératif du procédé permet d'affiner les paramètres R, L, C, G estimés notamment du fait que le filtrage des paramètres $\alpha$, $\beta$ est amélioré à chaque itération.

Alternativement, il est également possible de paramétrer le nombre d'itérations du procédé en fonction d'un critère de convergence qui peut consister à comparer le degré de similitude à un seuil de convergence et à arrêter les itérations lorsque la convergence est obtenue, autrement dit lorsque le degré de similitude est supérieur au seuil de convergence. Cette variante de fonctionnement permet d'optimiser le nombre d'itérations du procédé.

Comme explicité ci-dessus, à chaque itération, il est aussi possible d'effectuer une décimation en fréquence des mesures des paramètres $\alpha$, $\beta$ avant filtrage.

Les applications du procédé selon l'invention sont nombreuses. On peut citer sans être exhaustif ni limitatif les applications suivantes : le suivi du vieillissement d'un câble à partir du suivi de l'évolution de ses paramètres linéiques, la définition d'une base de données contenant ces paramètres ou l'amélioration de méthodes de réflectométrie connues.

Les paramètres estimés peuvent évoluer si certains paramètres physiques externes, tels que la température, l'humidité ou tout autre paramètre environnemental du câble évoluent également. Aussi, l'application du procédé selon l'invention peut permettre un suivi des caractéristiques d'un câble en fonction de l'évolution de son environnement physique.

La présente invention peut s'implémenter à partir d'éléments matériel et/ou logiciel. En particulier, le procédé selon l'invention peut être disponible en tant que produit programme d'ordinateur sur un support lisible par ordinateur. Le support peut être électronique, magnétique, optique ou électromagnétique.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués (*"Cloud computing"*), éventuellement avec des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant à un dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

L'invention peut également être mise en œuvre par des moyens matériels ou des moyens matériels et logiciels. Par exemple, l'invention peut être exécutée par un dispositif couplé aux moyens de mesure AM représentés sur le schéma de la figure 1.

Un tel dispositif peut utiliser un ou plusieurs circuits électronique dédiés ou un circuit à usage général. La technique de l'invention peut se réaliser sur une machine de calcul reprogrammable (un processeur ou un micro contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Selon un mode de réalisation, le dispositif selon l'invention comprend au moins un support de stockage lisible par ordinateur (RAM, ROM, EEPROM, mémoire flash ou une autre technologie de mémoire, CD-ROM, DVD ou un autre support à disque optique, cassette magnétique, bande magnétique, disque de stockage magnétique ou un autre dispositif de stockage, ou un autre support de stockage non transitoire lisible par ordinateur) codé avec un programme d'ordinateur (c'est-à-dire plusieurs instructions exécutables) qui, lorsqu'il est exécuté sur un processeur ou plusieurs processeurs, effectue les fonctions des modes de réalisation décrits précédemment.

A titre d'exemple d'architecture matérielle adaptée à mettre en œuvre l'invention, un dispositif peut comporter un bus de communication auquel sont reliés une unité centrale de traitement ou microprocesseur (CPU, acronyme de « *Central Processing Unit* » en anglais), lequel processeur peut être *"multi-core"* ou *"many-core";* une mémoire morte (ROM, acronyme de « *Read Only Memory*» en anglais) pouvant comporter les programmes nécessaires à la mise en œuvre de l'invention; une mémoire vive ou mémoire cache (RAM, acronyme de « *Random Access Memory* » en anglais) comportant des registres adaptés à enregistrer des variables et paramètres créés et modifiés au cours de l'exécution des programmes précités ; et une interface de communication ou E/S (I/O acronyme de « *Input*/*ouput* » en anglais) adaptée à transmettre et à recevoir des données.

Dans le cas où l'invention est implantée sur une machine de calcul reprogrammable, le programme correspondant (c'est-à-dire la séquence d'instructions) peut être stocké dans ou sur un médium de stockage amovible (par exemple une carte SD, un DVD ou Bluray, un moyen de stockage de masse tel qu'un disque dur e.g. un SSD) ou non-amovible, volatile ou non-volatile, ce médium de stockage étant lisible partiellement ou totalement par un ordinateur ou un processeur. Le support lisible par ordinateur peut être transportable ou communicable ou mobile ou transmissible (i.e. par un réseau de télécommunication 2G, 3G, 4G, Wifi, BLE, fibre optique ou autre).

Références

[1] "Analysis of the parameters of a lossy coaxial cable for cable fault location", Shi, Troltzsch, Kanoun

[2] "Inverse Scattering Experiments for Electric Cable Soft Fault Diagnosis and Connector Location", Loete, Zhang, Sorine

[3] "S-Parameter-Based IC Interconnect Transmission Line Characterization", Eisenstadt

[4] "A Mathematical and Lumped-Element Model for Multiple Cascaded Lossy transmission Lines with Arbitrary impedances and discontinuities", Scott Huss

[5] "System simulation of network analysis for a lossy cable system", Qinghai Shi, Olfa Kanoun

[6] "Extraction of high frequency power cable characteristics from S-parameter measurements", R. Papazyan et al.

**Revendications**

**1.** Procédé de détermination d'au moins un paramètre linéique d'une ligne de transmission, mis en œuvre par ordinateur, ledit procédé comprenant les étapes suivantes :

• Déterminer (103) au moins une mesure du facteur de propagation complexe $\gamma$ en fonction de la fréquence à partir d'au moins une mesure réalisée sur la ligne de transmission,
• Déterminer (104) au moins une mesure de l'atténuation linéique $\alpha$ de la ligne de transmission égale à la partie réelle de la mesure du facteur de propagation complexe $\gamma$ et/ou au moins une mesure du facteur de phase $\beta$ de la ligne de transmission égale à la partie imaginaire de la mesure du facteur de propagation complexe $\gamma$,
• Filtrer (105) la mesure de l'atténuation linéique $\alpha$ et/ou la mesure du facteur de phase $\beta$ à partir d'un modèle de régression polynomial en fréquence dépendant des caractéristiques physiques de la ligne de transmission.

**2.** Procédé de détermination d'au moins un paramètre linéique d'une ligne de transmission selon la revendication 1 dans lequel le modèle de régression pour l'atténuation linéique est du type $\alpha(f) = a_0\sqrt{f} + a_1 f$ , où $a_0$ et $a_1$ sont deux nombres réels.

3. Procédé de détermination d'au moins un paramètre linéique d'une ligne de transmission selon l'une des revendications précédentes dans lequel le modèle de régression pour le facteur de phase est du type $\beta(f) = b_0 f$ où $b_0$ est un nombre réel.

4. Procédé de détermination d'au moins un paramètre linéique d'une ligne de transmission selon l'une des revendications précédentes comprenant en outre la détermination (106) d'une estimée d'au moins un paramètre linéique de la ligne de transmission parmi la résistance linéique, l'inductance linéique, la capacitance linéique ou la conductance linéique, à partir d'au moins une mesure parmi la mesure filtrée de l'atténuation linéique, la mesure filtrée du facteur de phase et la mesure du coefficient de réflexion $\rho_e$ à une première extrémité de la ligne de transmission, la dite estimée étant déterminée comme une fonction polynomiale de la fréquence.

5. Procédé de détermination d'au moins un paramètre linéique d'une ligne de transmission selon l'une des revendications précédentes comprenant en outre les étapes suivantes :

   • Déterminer (202) une nouvelle estimée $X_i$ d'un paramètre caractéristique de la propagation dans la ligne de transmission à partir de ladite estimée d'au moins un paramètre linéique de la ligne de transmission,
   • Mesurer (203) le degré de similitude entre la nouvelle estimée $X_i$ et une mesure X du même paramètre caractéristique.

6. Procédé de détermination d'au moins un paramètre linéique d'une ligne de transmission selon la revendication 5 dans lequel le paramètre caractéristique de la propagation dans la ligne de transmission est le facteur de propagation complexe $\gamma$ ou une fonction de ce paramètre.

7. Procédé de détermination d'au moins un paramètre linéique d'une ligne de transmission selon l'une des revendications précédentes dans lequel la mesure du facteur de propagation complexe $\gamma$ est déterminée à l'aide des étapes suivantes :

   • Déterminer (101) une mesure H de la fonction de transfert fréquentielle de la ligne de transmission,
   • Déterminer (102) une mesure du coefficient de réflexion $\rho_e$ à une première extrémité de la ligne de transmission,
   • Déterminer (103) une mesure du facteur de propagation complexe $\gamma$ à partir de la mesure H de la fonction de transfert fréquentielle, de la mesure du coefficient de réflexion $\rho_e$ à une première extrémité de la ligne de transmission et d'une estimée de la longueur de la ligne de transmission,

8. Procédé de détermination d'au moins un paramètre linéique d'une ligne de transmission selon la revendication 7 dans lequel la mesure H de la fonction de transfert fréquentielle de la ligne de transmission est déterminée (101) à l'aide d'une méthode de réflectométrie fréquentielle à partir de l'injection, à une première extrémité de la ligne, d'un signal de réflectométrie.

9. Procédé de détermination d'au moins un paramètre linéique d'une ligne de transmission selon la revendication 8 dans lequel la mesure du coefficient de réflexion $\rho_e$ en entrée de la ligne de transmission est déterminée (102) par une moyenne, sur une bande fréquentielle donnée, de la mesure H de la fonction de transfert fréquentielle de la ligne de transmission.

10. Procédé de détermination d'au moins un paramètre linéique d'une ligne de transmission selon la revendication 7 dans lequel la mesure H de la fonction de transfert fréquentielle de la ligne de transmission est déterminée (101) à l'aide d'une méthode de réflectométrie temporelle à partir de l'injection, à une première extrémité de la ligne, d'un signal de réflectométrie.

11. Procédé de détermination d'au moins un paramètre linéique d'une ligne de transmission selon la revendication 10 dans lequel la mesure du coefficient de réflexion $\rho_e$ en entrée de la ligne de transmission est déterminée (102) par la mesure de l'amplitude du pic du signal de réflectométrie réfléchi au point d'injection.

12. Procédé de détermination d'au moins un paramètre linéique d'une ligne de transmission selon l'une des revendications 7 à 11 comprenant en outre les étapes suivantes :

   • Déterminer (201) une mesure de l'impédance caractéristique $Z_c$ de la ligne de transmission ou une mesure du coefficient de réflexion à une seconde extrémité de la ligne de transmission à partir de la mesure du coefficient de réflexion $\rho_e$ à une première extrémité de la ligne de transmission.

• Déterminer (103) une mesure du facteur de propagation complexe $\gamma$ à partir de la mesure H de la fonction de transfert fréquentielle et de la mesure de l'impédance caractéristique $Z_c$ de la ligne de transmission ou de la mesure du coefficient de réflexion à une seconde extrémité de la ligne de transmission.

13. Procédé de détermination d'au moins un paramètre linéique d'une ligne de transmission selon l'une des revendications 5 à 12 dans lequel le paramètre caractéristique de la propagation dans la ligne de transmission est la fonction de transfert fréquentielle H ou l'impédance caractéristique $Z_c$ ou une fonction de l'un de ses paramètres.

14. Procédé de détermination d'au moins un paramètre linéique d'une ligne de transmission selon l'une des revendications 5 à 13 dans lequel le degré de similitude est mesuré (202) par le calcul d'un coefficient de détermination entre la nouvelle estimée d'un paramètre caractéristique $X_i$ de la propagation dans la ligne de transmission et la mesure X du même paramètre caractéristique.

15. Procédé de détermination d'au moins un paramètre linéique d'une ligne de transmission selon l'une des revendications 4 à 14 comprenant en outre les étapes suivantes :

• Déterminer (103) une nouvelle estimée $\gamma_i$ du facteur de propagation complexe de la ligne de transmission à partir des estimées de la résistance linéique, de l'inductance linéique, de la capacitance linéique et de la conductance linéique de la ligne de transmission,
• exécuter les étapes (104,105,106) du procédé permettant de déterminer une estimée d'au moins un paramètre linéique de la ligne de transmission à partir de la nouvelle estimée $\gamma_i$ du facteur de propagation complexe.

16. Procédé de détermination d'au moins un paramètre linéique d'une ligne de transmission selon l'une des revendications 5 à 15 dans lequel les étapes du procédé sont itérées un nombre donné de fois et les paramètres linéiques retenus sont ceux déterminés à l'itération correspondant au degré de similitude le plus élevé.

17. Procédé de détermination d'au moins un paramètre linéique d'une ligne de transmission selon l'une des revendications 5 à 15 dans lequel les étapes du procédé sont itérées tant que le degré de similitude n'a pas atteint une valeur donnée.

18. Procédé de détermination d'au moins un paramètre linéique d'une ligne de transmission selon l'une des revendications précédentes dans lequel la ligne de transmission est un câble coaxial ou un câble bifilaire ou un câble torsadé.

19. Procédé de détermination d'au moins un paramètre linéique d'une ligne de transmission selon l'une des revendications précédentes comprenant en outre une étape de décimation en fréquence appliquée à une pluralité de mesures de l'atténuation linéique $\alpha$ et/ou de mesures du facteur de phase $\beta$ avant l'étape de filtrage (105).

20. Programme d'ordinateur comportant des instructions pour l'exécution du procédé de détermination d'au moins un paramètre linéique d'une ligne de transmission selon l'une quelconque des revendications 1 à 19, lorsque le programme est exécuté par un processeur.

21. Dispositif comprenant des premiers moyens de mesure connectés à une ligne de transmission et des seconds moyens de calcul configurés pour exécuter le procédé de détermination d'au moins un paramètre linéique d'une ligne de transmission selon l'une quelconque des revendications 1 à 19.

**Patentansprüche**

1. Verfahren zur Bestimmung mindestens eines linearen Parameters einer Übertragungsleitung, ausgeführt von einem Computer, wobei das Verfahren die folgenden Schritte beinhaltet:

• Bestimmen (103) mindestens eines Maßes des komplexen Ausbreitungsfaktors $\gamma$ in Abhängigkeit von der Frequenz auf der Basis von mindestens einer an der Übertragungsleitung durchgeführten Messung,
• Bestimmen (104) mindestens eines Maßes der linearen Dämpfung $\alpha$ der Übertragungsleitung gleich dem Realteil der Messung des komplexen Ausbreitungsfaktors $\gamma$ und/oder mindestens eines Maßes des Phasenfaktors $\beta$ der Übertragungsleitung gleich dem Imaginärteil der Messung des komplexen Ausbreitungsfaktors $\gamma$,
• Filtern (105) des Maßes der linearen Dämpfung $\alpha$ und/oder des Maßes des Phasenfaktors $\beta$ auf der Basis eines polynomischen Frequenzregressionsmodells in Abhängigkeit von den physikalischen Eigenschaften der Übertragungsleitung.

2. Verfahren zur Bestimmung mindestens eines linearen Parameters einer Übertragungsleitung nach Anspruch 1, wobei das Regressionsmodell für die lineare Dämpfung vom Typ $a(f) = a_0 \sqrt{f} + a_1 f$ ist, wobei $a_0$ und $a_1$ zwei reelle Zahlen sind.

3. Verfahren zur Bestimmung mindestens eines linearen Parameters einer Übertragungsleitung nach einem der vorherigen Ansprüche, wobei das Regressionsmodell für den Phasenfaktor vom Typ $\beta(f) = b_0 f$ ist, worin $b_0$ eine reelle Zahl ist.

4. Verfahren zur Bestimmung mindestens eines linearen Parameters einer Übertragungsleitung nach einem der vorherigen Ansprüche, das ferner das Bestimmen (106) einer Schätzung mindestens eines linearen Parameters der Übertragungsleitung aus dem linearen Widerstand, der linearen Induktivität, der linearen Kapazität oder dem linearen Leitwert auf der Basis von mindestens einer Messung aus der gefilterten Messung der linearen Dämpfung, der gefilterten Messung des Phasenfaktors und der Messung des Reflexionskoeffizienten $\rho_e$ an einem ersten Ende der Übertragungsleitung beinhaltet, wobei der Schätzwert als eine Polynomfunktion der Frequenz bestimmt wird.

5. Verfahren zur Bestimmung mindestens eines linearen Parameters einer Übertragungsleitung nach einem der vorherigen Ansprüche, das ferner die folgenden Schritte beinhaltet:

   • Bestimmen (202) einer neuen Schätzung $X_i$ eines charakteristischen Parameters der Ausbreitung in der Übertragungsleitung auf der Basis der Schätzung mindestens eines linearen Parameters der Übertragungsleitung,
   • Messen (203) des Ähnlichkeitsgrads zwischen der neuen Schätzung $X_i$ und einem Maß X desselben charakteristischen Parameters.

6. Verfahren zur Bestimmung mindestens eines linearen Parameters einer Übertragungsleitung nach Anspruch 5, wobei der charakteristische Parameter der Ausbreitung in der Übertragungsleitung der komplexe Ausbreitungsfaktor $\gamma$ oder eine Funktion dieses Parameters ist.

7. Verfahren zur Bestimmung mindestens eines linearen Parameters einer Übertragungsleitung nach einem der vorherigen Ansprüche, wobei das Maß des komplexen Ausbreitungsfaktors $\gamma$ mit Hilfe der folgenden Schritte bestimmt wird:

   • Bestimmen (101) eines Maßes H der Frequenztransferfunktion der Übertragungsleitung,
   • Bestimmen (102) eines Maßes des Reflexionskoeffizienten $\rho_e$ an einem ersten Ende der Übertragungsleitung,
   • Bestimmen (103) eines Maßes des komplexen Ausbreitungsfaktors $\gamma$ auf der Basis des Maßes H der Frequenztransferfunktion, des Maßes des Reflexionskoeffizienten $\rho_e$ an einem ersten Ende der Übertragungsleitung und einer Schätzung der Länge der Übertragungsleitung.

8. Verfahren zur Bestimmung mindestens eines linearen Parameters einer Übertragungsleitung nach Anspruch 7, wobei das Maß H der Frequenztransferfunktion der Übertragungsleitung mittels eines Frequenzreflektometrieverfahrens auf der Basis der Einspeisung eines Reflektometriesignals an einem ersten Ende der Leitung bestimmt wird (101).

9. Verfahren zur Bestimmung mindestens eines linearen Parameters einer Übertragungsleitung nach Anspruch 8, wobei das Maß des Reflexionskoeffizienten $\rho_e$ am Eingang der Übertragungsleitung durch Mittelwertbildung des Maßes H der Frequenztransferfunktion der Übertragungsleitung über ein gegebenes Frequenzband bestimmt wird (102).

10. Verfahren zur Bestimmung mindestens eines linearen Parameters einer Übertragungsleitung nach Anspruch 7, wobei das Maß H der Frequenztransferfunktion der Übertragungsleitung mittels eines Verfahrens der Zeitdomänereflektometrie auf der Basis der Einspeisung eines Reflexionssignals an einem ersten Ende der Leitung bestimmt wird (101).

11. Verfahren zur Bestimmung mindestens eines linearen Parameters einer Übertragungsleitung nach Anspruch 10, wobei das Maß des Reflexionskoeffizienten $\rho_e$ am Eingang der Übertragungsleitung durch Messen der Amplitude der Spitze des am Einspeisungspunkt reflektierten Reflektometriesignals bestimmt wird (102).

12. Verfahren zur Bestimmung mindestens eines linearen Parameters einer Übertragungsleitung nach einem der Ansprüche 7 bis 11, das ferner die folgenden Schritte beinhaltet:

• Bestimmen (201) eines Maßes der charakteristischen Impedanz $Z_c$ der Übertragungsleitung oder eines Maßes des Reflexionskoeffizienten an einem zweiten Ende der Übertragungsleitung auf der Basis des Maßes des Reflexionskoeffizienten $\rho_e$ an einem ersten Ende der Übertragungsleitung,
• Bestimmen (103) eines Maßes des komplexen Ausbreitungsfaktors $\gamma$ auf der Basis des Maßes H der Frequenztransferfunktion und des Maßes der charakteristischen Impedanz $Z_c$ der Übertragungsleitung oder des Maßes des Reflexionskoeffizienten an einem zweiten Ende der Übertragungsleitung.

13. Verfahren zur Bestimmung mindestens eines linearen Parameters einer Übertragungsleitung nach einem der Ansprüche 5 bis 12, wobei der charakteristische Parameter der Ausbreitung in der Übertragungsleitung die Frequenztransferfunktion H oder die charakteristische Impedanz $Z_c$ oder eine Funktion eines seiner Parameter ist.

14. Verfahren zur Bestimmung mindestens eines linearen Parameters einer Übertragungsleitung nach einem der Ansprüche 5 bis 13, wobei der Ähnlichkeitsgrad durch Berechnen eines Bestimmungskoeffizienten zwischen der neuen Schätzung eines charakteristischen Parameters $X_i$ der Ausbreitung in der Übertragungsleitung und des Maßes X desselben charakteristischen Parameters gemessen wird (202).

15. Verfahren zur Bestimmung mindestens eines linearen Parameters einer Übertragungsleitung nach einem der Ansprüche 4 bis 14, das ferner die folgenden Schritte beinhaltet:

• Bestimmen (103) einer neuen Schätzung $\gamma_i$ des komplexen Ausbreitungsfaktors der Übertragungsleitung auf der Basis der Schätzungen des linearen Widerstandes, der linearen Induktivität, der linearen Kapazität und des linearen Leitwertes der Übertragungsleitung,
• Ausführen der Schritte (104, 105, 106) des Verfahrens, die die Bestimmung einer Schätzung mindestens eines linearen Parameters der Übertragungsleitung auf der Basis der neuen Schätzung $\gamma_i$ des komplexen Ausbreitungsfaktors ermöglichen.

16. Verfahren zur Bestimmung mindestens eines linearen Parameters einer Übertragungsleitung nach einem der Ansprüche 5 bis 15, wobei die Verfahrens schritte eine gegebene Anzahl von Malen iteriert werden und die ausgewählten linearen Parameter diejenigen sind, die bei der Iteration entsprechend dem höchsten Ähnlichkeitsgrad bestimmt wurden.

17. Verfahren zur Bestimmung mindestens eines linearen Parameters einer Übertragungsleitung nach einem der Ansprüche 5 bis 15, wobei die Verfahrens schritte iteriert werden, solange der Ähnlichkeitsgrad einen vorgegebenen Wert nicht erreicht hat.

18. Verfahren zur Bestimmung mindestens eines linearen Parameters einer Übertragungsleitung nach einem der vorherigen Ansprüche, wobei die Übertragungsleitung ein Koaxialkabel oder ein zweiadriges Kabel oder ein verdrilltes Kabel ist.

19. Verfahren zur Bestimmung mindestens eines linearen Parameters einer Übertragungsleitung nach einem der vorherigen Ansprüche, das ferner einen Frequenzdezimierungsschritt umfasst, der auf eine Mehrzahl von Messungen der linearen Dämpfung $\alpha$ und/oder Messungen des Phasenfaktors $\beta$ vor dem Filterschritt (105) angewendet wird.

20. Computerprogramm, das Befehle zur Ausführung des Verfahrens zur Bestimmung mindestens eines linearen Parameters einer Übertragungsleitung nach einem der Ansprüche 1 bis 19 aufweist, wenn das Programm von einem Prozessor ausgeführt wird.

21. Vorrichtung, die mit einer Übertragungsleitung verbundene erste Messmittel und zweite Rechenmittel umfasst, konfiguriert zum Ausführen des Verfahrens zur Bestimmung mindestens eines linearen Parameters einer Übertragungsleitung nach einem der Ansprüche 1 bis 19.

**Claims**

1.  A computer-implemented method for determining at least one linear parameter of a transmission line, said method comprising the following steps:

    • determining (103) at least one measurement of a complex propagation factor $\gamma$ as a function of frequency from at least one measurement carried out on the transmission line,
    • determining (104) at least one measurement of the linear attenuation $\alpha$ of the transmission line equal to the real part of the measurement of the complex propagation factor $\gamma$ and/or at least one measurement of the phase factor $\beta$ of the transmission line equal to the imaginary part of the measurement of the complex propagation factor $\gamma$,
    • filtering (105) the measurement of the linear attenuation $\alpha$ and/or the measurement of the phase factor $\beta$ with a polynomial frequency regression model dependent on the physical characteristics of the transmission line.

2.  The method for determining at least one linear parameter of a transmission line according to claim 1, wherein the regression model for the linear attenuation is of the type $\alpha(f) = a_0\sqrt{f} + a_1 f$, where $a_0$ and $a_1$ are two real numbers.

3.  The method for determining at least one linear parameter of a transmission line according to any of the preceding claims, wherein the regression model for the phase factor is of the type $\beta(f) = b_0 f$ where $b_0$ is a real number.

4.  The method for determining at least one linear parameter of a transmission line according to any of the preceding claims, furthermore comprising the determination (106) of an estimate of at least one linear parameter of the transmission line among the linear resistance, the linear inductance, the linear capacitance or the linear conductance, from at least one measurement among the filtered measurement of the linear attenuation, the filtered measurement of the phase factor and the measurement of the reflection coefficient $\rho_e$ at a first end of the transmission line, said estimate being determined as a polynomial function of frequency.

5.  The method for determining at least one linear parameter of a transmission line according to any of the preceding claims, furthermore comprising the following steps:

    • determining (202) a new estimate $X_i$ of a characteristic parameter of the propagation in the transmission line from said estimate of at least one linear parameter of the transmission line,
    • measuring (203) the degree of similarity between the new estimate $X_i$ and a measurement X of the same characteristic parameter.

6.  The method for determining at least one linear parameter of a transmission line according to claim 5, wherein the characteristic parameter of the propagation in the transmission line is the complex propagation factor $\gamma$ or a function of this parameter.

7.  The method for determining at least one linear parameter of a transmission line according to any of the preceding claims, wherein the measurement of the complex propagation factor $\gamma$ is determined with the following steps:

    • determining (101) a measurement H of the frequency transfer function of the transmission line,
    • determining (102) a measurement of the reflection coefficient $\rho_e$ at a first end of the transmission line,
    • determining (103) a measurement of the complex propagation factor $\gamma$ from the measurement H of the frequency transfer function, the measurement of the reflection coefficient $\rho_e$ at a first end of the transmission line and an estimate of the length of the transmission line.

8.  The method for determining at least one linear parameter of a transmission line according claim 7, wherein the measurement H of the frequency transfer function of the transmission line is determined (101) with a frequency-domain reflectometry procedure based on injecting, at a first end of the line, a reflectometry signal.

9.  The method for determining at least one linear parameter of a transmission line according claim 8, wherein the measurement of the reflection coefficient $\rho_e$ at the input of the transmission line is determined (102) by an average, over a given frequency band, of the measurement H of the frequency transfer function of the transmission line.

**10.** The method for determining at least one linear parameter of a transmission line according claim 7, wherein the measurement H of the frequency transfer function of the transmission line is determined (101) with the aid of a time-domain reflectometry procedure based on injecting, at a first end of the line, a reflectometry signal.

**11.** The method for determining at least one linear parameter of a transmission line according to claim 10, wherein the measurement of the reflection coefficient $\rho_e$ at the input of the transmission line is determined (102) by measuring the amplitude of the spike of the reflected reflectometry signal at the injection point.

**12.** The method for determining at least one linear parameter of a transmission line according to any of claims 7 to 11, further comprising the following steps:

• determining (201) a measurement of the characteristic impedance $Z_c$ of the transmission line or a measurement of the reflection coefficient at a second end of the transmission line from the measurement of the reflection coefficient $\rho_e$ at a first end of the transmission line,
• determining (103) a measurement of the complex propagation factor $\gamma$ from the measurement H of the frequency transfer function and of the measurement of the characteristic impedance $Z_c$ of the transmission line or of the measurement of the reflection coefficient at a second end of the transmission line.

**13.** The method for determining at least one linear parameter of a transmission line according to any of claims 5 to 12, wherein the characteristic parameter of the propagation in the transmission line is the frequency transfer function H or the characteristic impedance $Z_c$ or a function of one of its parameters.

**14.** The method for determining at least one linear parameter of a transmission line according to any of claims 5 to 13, wherein the degree of similarity is measured by calculating a coefficient of determination between the new estimate of a characteristic parameter $X_i$ of the propagation in the transmission line and the measurement X of the same characteristic parameter.

**15.** The method for determining at least one linear parameter of a transmission line according to any of claims 4 to 14, further comprising the following steps:

• determining (103) a new estimate $\gamma_i$ of the complex propagation factor of the transmission line from the estimates of the linear resistance, of the linear inductance, of the linear capacitance and of the linear conductance of the transmission line,
• executing the steps (104, 105, 106) of the method making it possible to determine an estimate of at least one linear parameter of the transmission line from the new estimate $\gamma_i$ of the complex propagation factor.

**16.** The method for determining at least one linear parameter of a transmission line according to any of claim 5 to 15, wherein the steps of the method are iterated a given number of times and the linear parameters retained are those determined at the iteration corresponding to the highest degree of similarity.

**17.** The method for determining at least one linear parameter of a transmission line according to any of claims 5 to 15, wherein the steps of the method are iterated as long as the degree of similarity has not attained a given value.

**18.** The method for determining at least one linear parameter of a transmission line according to any of the preceding claims, wherein the transmission line is a coaxial cable or a bifilar cable or a twisted cable.

**19.** The method for determining at least one linear parameter of a transmission line according to any of the preceding claims, furthermore comprising a frequency decimation step applied to a plurality of measurements of the linear attenuation $\alpha$ and/or of measurements of the phase factor $\beta$ before the filtering step (105).

**20.** A computer program having instructions for executing the method for determining at least one linear parameter of a transmission line according to any of claims 1 to 19, when the program is executed on a processor.

**21.** A device comprising first measurement means connected to a transmission line and second computation means configured to execute the method for determining at least one linear parameter of a transmission line according to any of claims 1 to 19.

FIG.1

FIG.2

## RÉFÉRENCES CITÉES DANS LA DESCRIPTION

**Documents brevets cités dans la description**

- FR 1355377
- WO 2014065674 A1
- US 2011071776 A1
- US 5502392 A

**Littérature non-brevet citée dans la description**

- **DOUNAVIS A et al.** Passive Closed-Form Transmission Line Macromodel Using Method of Characteristics. *IEEE Transactions on Advanced Packaging*
- Spectrum management for loop transmission systems. *TR41.9/99-08-046 American National Standard for Télécommunications*